# EUROPEAN PATENT SPECIFICATION

(11) **EP 4 160 669 B1**
(45) Date of publication and mention of the grant of the patent: **24.09.2025**
(21) Application number: 21811808.1
(22) Date of filing: 17.05.2021
(51) Int. Cl.: H01L 23/373, B32B 27/20, B32B 27/08, B32B 15/092, C08K 3/38, B32B 27/38

(54) **THERMALLY CONDUCTIVE SHEET WITH METAL PLATE AND METHOD FOR PRODUCING THERMALLY CONDUCTIVE SHEET**
WÄRMELEITFÄHIGES BLECH MIT METALLPLATTE UND VERFAHREN ZUM HERSTELLEN EINES WÄRMELEITFÄHIGEN BLECHS
FEUILLE THERMOCONDUCTRICE AVEC PLAQUE MÉTALLIQUE ET PROCÉDÉ DE FABRICATION D'UNE FEUILLE THERMOCONDUCTRICE

(30) Priority: 26.05.2020 JP 2020091379
(43) Date of publication of application: 05.04.2023
(73) Proprietor: Sumitomo Bakelite Co., Ltd., Shinagawa-ku Tokyo 140-0002 (JP)
(72) Inventor: KAGAWA, Mika, Tokyo 140-0002 (JP)
(74) Representative: Ter Meer Steinmeister & Partner
(86) International application number: PCT/JP2021/018560
(87) International publication number: WO 2021/241298

(56) References cited:
- JP-A- 2008 010 897
- JP-A- 2012 039 061
- JP-A- 2012 039 061
- US-A1- 2012 188 730

## Description

### TECHNICAL FIELD

The present invention relates to a thermally conductive sheet with a metal plate and a method of producing a thermally conductive sheet. More specifically, the present invention relates to a thermally conductive sheet with a metal plate for use as a thermally conductive sheet that transfers heat from a heat generating member, such as an electrical/electronic device, to a heat radiating member, and a method for producing a thermally conductive sheet.

### BACKGROUND ART

Conventionally, a resin or the like is made to contain an inorganic filler, whereby the strength is improved or the thermal conductive properties are improved as compared with a resin alone. For example, a polymer composition in which an inorganic filler that is used to improve thermal conductive properties is dispersed in a base resin using an epoxy resin is widely used in a thermally conductive sheet or electronic component applications such as sealing of a chip component or formation of an insulating layer of a metal-based circuit board that is used in a power module or the like.

Here, examples of the inorganic filler having excellent thermal conductive properties and electrical insulation properties include alumina, boron nitride, silica, and aluminum nitride. Among them, boron nitride (BN) is suitable for use in the thermally conductive sheet from the fact that the boron nitride also has excellent chemical stability in addition to the thermal conductive properties and the electrical insulation properties, is non-toxic, and is relatively inexpensive.

As the thermally conductive sheet containing boron nitride, a thermally conductive sheet in which secondary particles having isotropic thermal conductive properties, such as secondary aggregate particles obtained by aggregating primary particles of scaly boron nitride or secondary sintered particles obtained by further sintering the secondary aggregate particles, are dispersed in a thermosetting resin has been proposed (see, for example, Patent Documents 1 and 2). In such a thermally conductive sheet, the thermal conductive properties in the thickness direction of the sheet are enhanced by the secondary particles having isotropic thermal conductive properties.

In recent years, the thermally conductive sheet has been exposed to higher temperatures with the increase in withstand voltage and large current of electrical/electronic devices. For this reason, in order to further improve the thermal conductive properties of the thermally conductive sheet, there is a tendency to increase the blending amount of the inorganic filler. However, in a case where the blending amount of the inorganic filler is increased, defects such as voids and cracks are likely to occur in the thermally conductive sheet, and the electrical insulation properties of the thermally conductive sheet may be deteriorated.

Further such thermally conductive sheets are disclosed in Patent Documents 3 and 4.

### RELATED DOCUMENT

### PATENT DOCUMENT

[Patent Document 1] Japanese Unexamined Patent Publication No. 2003-60134
[Patent Document 2] International Publication No. 2009/041300
[Patent Document 3]: US Patent Publication No. US 2012 188730 A1
[Patent Document 4]: Japanese Patent Publication No. JP 2012 039061 A

### SUMMARY OF THE INVENTION

### TECHNICAL PROBLEM

The present invention has been made in view of the above problems, and an object thereof is to provide a thermally conductive sheet having improved heat resistance and crack resistance in a well-balanced manner.

### SOLUTION TO PROBLEM

As a result of diligent studies, the present inventor has found that a thermally conductive sheet having both heat resistance and crack resistance can be obtained by controlling the amount of warpage of the sheet to a specific range, and has completed the present invention.

According to the present invention,
there is provided a thermally conductive sheet with a metal plate including:
a metal plate; and
a thermally conductive sheet laminated over the metal plate and containing a thermosetting resin and boron nitride particles,
in which an average particle size of the boron nitride particles is 10 µm or more and 100 µm or less, and
an amount of warpage of the thermally conductive sheet when the metal plate is removed is 0.15 mm or more and 1.30 mm or less.

Further, according to the present invention,
there is provided a method of producing a thermally conductive sheet, including:
a step of applying a first thermally conductive resin composition onto a first base film and heating the applied first thermally conductive resin composition to form a first thermally conductive resin layer in a B-stage state, and separating the first thermally conductive resin layer from the first base film to obtain a first thermally conductive resin film;
a step of applying a second thermally conductive resin composition onto a second base film and heating the applied second thermally conductive resin composition to form a first thermally conductive resin layer in a B-stage state, and separating the first thermally conductive resin layer from the second base film to obtain a second thermally conductive resin film;
a step of laminating the second thermally conductive resin film over the first thermally conductive resin film to obtain a laminated film; and
a step of heat-pressing and curing the laminated film to obtain a thermally conductive sheet,
in which the first thermally conductive resin composition and the second thermally conductive resin composition contain a thermosetting resin and boron nitride particles, and
an average particle size of the boron nitride particles is 10 µm or more and 100 µm or less.

Furthermore, according to the present invention,
there is provided a method of producing a thermally conductive sheet, including:
a step of applying a thermally conductive resin composition onto a base film and heating the applied thermally conductive resin composition to form a thermally conductive resin layer in a B-stage state, and separating the thermally conductive resin layer from the base film to obtain a thermally conductive resin film; and
a step of heat-pressing and curing the thermally conductive resin film to obtain a thermally conductive sheet,
in which the thermally conductive resin composition contains a thermosetting resin composition and boron nitride particles, and
an average particle size of the boron nitride particles is 10 µm or more and 100 µm or less.

### ADVANTAGEOUS EFFECTS OF INVENTION

According to the present invention, there is provided a thermally conductive sheet having both heat resistance and crack resistance, and a method of producing such a thermally conductive sheet.

### BRIEF DESCRIPTION OF THE DRAWINGS

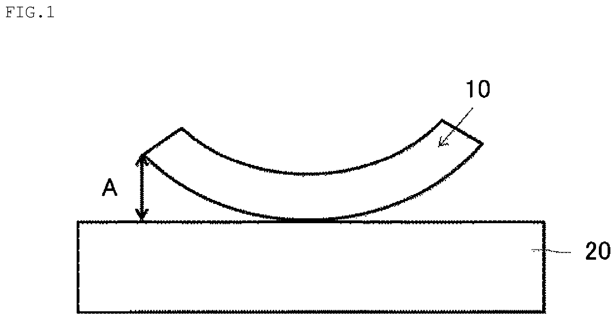

Fig. 1 is a schematic view showing a method of measuring an amount of warpage of a thermally conductive sheet of the present embodiment.

### DESCRIPTION OF EMBODIMENTS

Hereinafter, embodiments of the present invention will be described.

A thermally conductive sheet according to the present embodiment is provided in the form of a thermally conductive sheet with a metal plate laminated on a metal plate. In the present embodiment, the thermally conductive sheet with a metal plate includes a metal plate and a thermally conductive sheet laminated on the metal plate. Here, the thermally conductive sheet contains a thermosetting resin and boron nitride particles, and the average particle size of the boron nitride particles is 10 µm or more and 100 µm or less. In the thermally conductive sheet with a metal plate of the present embodiment, the amount of warpage of the thermally conductive sheet itself in a case where the metal plate is removed is 0.15 mm or more and 1.30 mm or less. Here, the amount of warpage of the thermally conductive sheet is the maximum value of the warpage (Z-axis) when a single thermally conductive sheet is placed on a plane stage (X-axis and Y-axis).

In the thermally conductive sheet of the present embodiment, the thermosetting resin contains boron nitride particles in a relatively high blending amount in order to ensure thermal conductive properties. The present inventor has found that the amount of warpage of the thermally conductive sheet is controlled within a specific range so that the obtained thermally conductive sheet has high heat resistance and excellent crack resistance even in a case where a high blending amount of boron nitride particles is used. It is considered that high heat resistance can be obtained by using a high blending amount of boron nitride. Further, the boron nitride particles having a large particle size are used, so that it is possible to control the amount of warpage of the thermally conductive sheet. Although the reason for this is not always clear, in the boron nitride particles having a large particle size, the concentration gradient of the boron nitride particles in the thickness direction of the obtained sheet is generated because the boron nitride particles precipitate during film formation. More specifically, as described below, the thermally conductive sheet of the present embodiment is obtained by a step of coating a base film with a thermally conductive resin composition (application) and heating the thermally conductive resin composition to form a resin film (resin layer). When the base film is coated with the thermally conductive resin composition, a layer having a high resin concentration and a layer having a high boron nitride particle concentration are formed, and such a difference in composition causes warpage. In the present embodiment, it is considered that the amount of warpage of the obtained thermally conductive sheet can be controlled to 1.30 mm or less by using the boron nitride particles having a relatively large particle size. A thermally conductive sheet of which the amount of warpage is 1.30 mm or less has excellent moisture absorption and heat resistance because the thermally conductive sheet has almost or no cracks during use, so that the thermally conductive sheet can be used as a heat radiating material with excellent reliability and has sufficient heat resistance to withstand high temperature use. In addition, in the thermally conductive sheet of the present embodiment, the amount of warpage is set to 0.15 mm or more, so that the resin-coated surface of the thermally conductive sheet can be discriminated. Here, the thermally conductive sheet of the present embodiment can be obtained by coating the base film with the thermally conductive resin composition (application) and heating the thermally conductive resin composition to form a resin film (resin layer), and then peeling off the base film from the resin film (resin layer). The resin-coated surface refers to a surface of the obtained thermally conductive sheet opposite to the surface in contact with the base film. In the step of forming the resin film (resin layer) in the method of producing the thermally conductive sheet, impurities in the resin composition are present on the surface of the resin film in close contact with the base film. It is possible to wash only the surface on the base film side to remove impurities by making the resin-coated surface and the surface on the base film side discriminable from each other, so that a thermally conductive sheet with excellent reliability can be produced efficiently.

In the present embodiment, the "thermally conductive sheet" refers to a sheet-like resin composition in a B-stage state obtained by semi-curing the thermally conductive resin composition. Further, a sheet obtained by curing a thermosetting resin sheet by heat treatment is referred to as a "cured product of the thermally conductive sheet".

The amount of warpage of the thermally conductive sheet of the present embodiment can be controlled by adjusting the material contained in the thermally conductive resin composition used for producing the sheet and the blending amount thereof, and by adjusting the production conditions of the thermally conductive sheet.

In one embodiment, the boron nitride particles used in the thermally conductive sheet are preferably aggregate particles of scaly boron nitride from the viewpoint of improving the thermal conductive properties. Such boron nitride particles are used, so that it is possible to obtain a cured product of a thermally conductive sheet having an excellent balance between thermal conductive properties and insulation properties.

In the present embodiment, the average particle size of the aggregate particles of scaly boron nitride is 10 µm or more and100 µm or less, preferably 20 µm or more and 100 µm or less, and more preferably 30 µm or more and 100 µm or less. With this, it is possible to realize a thermally conductive sheet having improved thermal conductive properties and crack resistance by reducing the amount of warpage.

In one embodiment, the boron nitride particles are contained preferably in an amount of 50% by mass or more and 95% by mass or less, more preferably in an amount of 55% by mass or more and 90% by mass or less, still more preferably in an amount of 60% by mass or more and 88% by mass or less, and particularly preferably in an amount of 70% by mass or more and 85% by mass or less, with respect to the entire thermally conductive sheet. The boron nitride particles are contained in the content of the above range, so that the uniformity of the film thickness of the obtained thermally conductive sheet can be improved, and the cured product of the thermally conductive sheet has high thermal conductive properties.

The thermally conductive sheet of the present embodiment contains a thermosetting resin. An epoxy resin is used as the thermosetting resin. As the epoxy resin, a resin generally used in the relevant field can be used, and for example, an epoxy resin having a phenol novolac skeleton or a cresol novolac skeleton, an epoxy resin having a dicyclopentadiene skeleton, an epoxy resin having a biphenyl skeleton, an epoxy resin having an adamantane skeleton, an epoxy resin having a phenol aralkyl skeleton, an epoxy resin having a biphenyl aralkyl skeleton, and an epoxy resin having a naphthalene aralkyl skeleton can be used. As the epoxy resin, an epoxy resin that is liquid at a room temperature can be used. As such an epoxy resin, an epoxy resin having a biphenol skeleton that is liquid at a room temperature is preferably used. These may be used alone or in combination of two or more.

In one embodiment, the epoxy resin is contained preferably in an amount of 1% by mass or more and 30% by mass or less, and more preferably in an amount of 5% by mass or more and 28% by mass or less, with respect to the entire thermally conductive sheet. The amount of the epoxy resin is within the above range, so that the handleability of the resin composition which is the material of the sheet is improved, and it becomes easy to form the thermally conductive sheet. Further, the amount of the epoxy resin is within the above range, so that the thermally conductive sheet having a smooth surface can be obtained without the unevenness caused by the boron nitride particles that appears on the surface of the obtained thermally conductive sheet.

The thermally conductive sheet contains other thermosetting resins in addition to the epoxy resin, which include a cyanate resin. The cyanate resin is contained, so that the insulation properties of the obtained cured product of the thermally conductive sheet at a high temperature is improved. Examples of the cyanate resin include a novolac type cyanate resin; a bisphenol type cyanate resin such as a bisphenol A type cyanate resin, a bisphenol E type cyanate resin, and a tetramethyl bisphenol F type cyanate resin; a naphthol aralkyl type cyanate resin obtained by a reaction between a naphthol aralkyl type phenolic resin and a cyanogen halide; a dicyclopentadiene type cyanate resin; and a biphenyl alkyl type cyanate resin, but the present invention is not limited thereto. In a case where the cyanate resin is used, the amount used is preferably 2% by mass or more and 25% by mass or less, and more preferably 5% by mass or more and 20% by mass or less, with respect to the entire thermally conductive sheet.

The thermally conductive sheet according to the present embodiment preferably contains a phenol-based curing agent or a curing catalyst. Examples of the phenol-based curing agent include a novolac type phenolic resin such as a phenol novolac resin, a cresol novolac resin, a naphthol novolac resin, an amino triazine novolac resin, a novolac resin, and a trisphenyl methane type phenol novolac resin; a modified phenolic resin such as a terpene-modified phenolic resin and a dicyclopentadiene-modified phenolic resin; an aralkyl type resin such as a phenol aralkyl resin having a phenylene skeleton and/or a biphenylene skeleton and a naphthol aralkyl resin having a phenylene skeleton and/or a biphenylene skeleton; bisphenol compounds such as bisphenol A and bisphenol F; and a resol type phenolic resin, and these may be used alone or in combination of two or more. In a case where the phenol-based curing agent is used, the amount used is preferably 0.1% by mass or more and 30% by mass, and more preferably 0.3% by mass or more and 15% by mass or less, with respect to the entire thermally conductive sheet.

Examples of the curing catalyst include organic metal salts such as zinc naphthenate, cobalt naphthenate, tin octylate, cobalt octylate, bisacetylacetonate cobalt (II), and trisacetylacetonate cobalt (III); tertiary amines such as triethylamine, tributylamine, and 1,4-diazabicyclo[2.2.2]octane; imidazoles such as 2-phenyl-4-methylimidazole, 2-ethyl-4-methylimidazole, 2,4-diethylimidazole, 2-phenyl-4-methyl-5-hydroxyimidazole, 2-phenyl-4,5-dihydroxymethylimidazole; organic phosphorus compounds such as triphenylphosphine, tri-p-tolylphosphine, tetraphenylphosphonium tetraphenylborate, triphenylphosphine triphenylborane, and 1,2-bis(diphenylphosphino)ethane; phenolic compounds such as phenol, bisphenol A, and nonylphenol; or organic acids such as acetic acid, benzoic acid, salicylic acid, p-toluenesulfonic acid, or mixtures thereof. These may be used alone or in combination of two or more. In a case where the curing catalyst is used, the amount used is preferably 0.001% by mass or more and 1% by mass with respect to the entire thermally conductive sheet.

The thermally conductive sheet of the present embodiment may further contain a coupling agent. The coupling agent is blended, so that the interface wettability between the epoxy resin and the boron nitride particles can be improved. As the coupling agent, an epoxy silane coupling agent, a cationic silane coupling agent, an aminosilane coupling agent, a titanate-based coupling agent, a silicone oil type coupling agent, and the like can be used, but the present invention is not limited thereto. In a case where the coupling agent is used, the coupling agent is used preferably in an amount of 0.1% by mass or more and 10% by mass or less, and more preferably in an amount of 0.5% by mass or more and 7% by mass or less, with respect to the entire thermally conductive sheet.

The thermally conductive sheet of the present embodiment may further contain a phenoxy resin. The phenoxy resin is used, so that the bending resistance of the thermally conductive sheet can be improved. As the phenoxy resin, a phenoxy resin having a bisphenol skeleton, a phenoxy resin having a naphthalene skeleton, a phenoxy resin having an anthracene skeleton, a phenoxy resin having a biphenyl skeleton, and the like can be used, but the present invention is not limited thereto. In a case where the phenoxy resin is used, the phenoxy resin is used preferably in an amount of 2% by mass or more and 15% by mass or less with respect to the entire thermally conductive sheet.

The thermally conductive sheet of the present embodiment may contain additives such as an antioxidant, a leveling agent, a foam breaker, and a dispersant as long as the effects of the present invention are not impaired.

The thermally conductive sheet with a metal plate of the present embodiment can be obtained by producing a varnish-like thermally conductive resin composition containing the above materials, applying this thermally conductive resin composition onto a metal plate, and heat-treating and drying the applied thermally conductive resin composition. More specifically, first, a resin varnish is prepared by adding the above resin component to a solvent. Boron nitride particles are added to this resin varnish and kneaded, whereby a varnish-like thermally conductive resin composition is obtained. Next, the obtained varnish-like thermally conductive resin composition is applied onto a metal plate and is dried, and the solvent is removed, whereby a sheet-like resin composition in a B-stage state can be obtained as the thermally conductive sheet. Examples of the metal plate include a metal foil constituting a peelable carrier material, a heat radiating member, and a lead frame. Further, the heat treatment for drying the thermally conductive resin composition is performed under the conditions of, for example, 80°C to 150°C and 5 minutes to 1 hour. The film thickness of the obtained thermally conductive sheet is, for example, 100 µm or more and 400 µm or less.

In another embodiment, a thermally conductive sheet can be produced by the following steps:
a step of applying a first thermally conductive resin composition onto a first base film and heating the applied first thermally conductive resin composition to form a first thermally conductive resin layer in a B-stage state, and separating the first thermally conductive resin layer from the first base film to obtain a first thermally conductive resin film;
a step of applying a second thermally conductive resin composition onto a second base film and heating the applied second thermally conductive resin composition to form a first thermally conductive resin layer in a B-stage state, and separating the first thermally conductive resin layer from the second base film to obtain a second thermally conductive resin film; and
a step of laminating the second thermally conductive resin film on the first thermally conductive resin film to obtain a laminated film.

Here, the first thermally conductive resin composition and the second thermally conductive resin composition can be produced by the same method as the above-described method of producing the varnish-like thermally conductive resin composition. Further, the first thermally conductive resin composition and the second thermally conductive resin composition may be the same or may have compositions different from each other.

In the thermally conductive sheet having a two-layer laminated structure obtained by the above method, the thicknesses of the first and second thermally conductive resin layers are each, for example, 50 µm or more and 200 µm or less, and the thickness of the thermally conductive sheet having the two-layer laminated structure obtained by laminating the first and second thermally conductive resin layers is, for example, 100 µm or more and 400 µm or less. The thicknesses of the first and second thermally conductive resin layers may be the same as or different from each other, but it is preferable that the thicknesses thereof are the same from the viewpoint that the amount of warpage can be easily controlled.

In still another embodiment, a thermally conductive sheet can be produced by the following steps:
a step of applying a thermally conductive resin composition onto a base film and heating the applied thermally conductive resin composition to form a thermally conductive resin layer in a B-stage state, and separating the thermally conductive resin layer from the base film to obtain a thermally conductive resin film; and
a step of heat-pressing and curing the thermally conductive resin film to obtain a thermally conductive sheet.

Here, the thermally conductive resin composition can be produced by the same method as the above-described method of producing a varnish-like thermally conductive resin composition. The thickness of the thermally conductive sheet having a single-layer structure obtained by the above method is, for example, 100 µm or more and 400 µm or less.

The base film is not particularly limited as long as the base film can withstand the above-described heating and drying conditions, and for example, a polyester-based film, a polypropylene-based film, a polyimide-based film, a polyamide-based film, a polysulfone-based film, and a polyetherketone-based film are used. The surfaces of these base films may be treated with a mold release agent.

In one embodiment, the specific gravity of the thermally conductive sheet in a B-stage state obtained as described above is preferably 1.0 or more and 1.9 or less. Within the above range, in a case where this sheet-like resin composition is cured to form a thermally conductive member, the thermally conductive member has sufficient thermal conductive properties.

The thermally conductive sheet of the present embodiment is provided, for example, between a heat-generating body, such as a semiconductor chip, and a substrate, such as a lead frame or a wiring board (interposer) on which the heat-generating body is mounted, or between the substrate and a heat radiating member, such as a heat sink. With this, it is possible to effectively radiate the heat generated from the heat-generating body to the outside of the semiconductor device while maintaining the insulation properties of the semiconductor device.

### Examples

Hereinafter, the present invention will be described with reference to Examples and Comparative Examples

### (Examples 1 to 4 and Comparative Examples 1 to 3)

### <1. Preparation of Thermosetting Resin Composition>

According to the formulation shown in Table 1, a thermosetting resin, a curing agent, and a curing catalyst were added to methyl ethyl ketone, which is a solvent, and the mixture was stirred, thereby obtaining a mixed solution. Next, boron nitride particles, which are an inorganic filler, were added to this mixed solution and premixed, and then kneaded with three rolls, thereby obtaining a varnish-like thermosetting resin composition in which the boron nitride particles were uniformly dispersed. Next, the obtained thermosetting resin composition was aged under the conditions of 60°C and 15 hours.

The components shown in Table 1 are as follows.

### (Thermosetting Resin)

·Epoxy resin 1: Epoxy resin having a dicyclopentadiene skeleton (XD-1000, manufactured by Nippon Kayaku Co., Ltd.)
·Cyanate resin 1: Phenol novolac type cyanate resin (PT-30, manufactured by LONZA KK.)

### (Curing Agent)

·Phenol-based curing agent 1: Trisphenyl methane type phenol novolac resin (MEH-7500, manufactured by Meiwa Plastics industries, LTD)

### (Curing Catalyst)

·Curing catalyst 1: 2-phenyl-4,5-dihydroxymethylimidazole (2PHZ-PW, manufactured by SHIKOKU CHEMICALS CORPORATION)

### (Inorganic Filler)

·Inorganic filler 1: Boron nitride particles (average particle size 40 µm)
·Inorganic filler 2: Boron nitride particles (average particle size 7 µm)

### <2. Production of Thermally Conductive Sheet>

·Sheet Production Method A

The above varnish-like thermally conductive resin composition was applied onto a PET film (dimensions 100 mm × 100 mm) and dried at 80°C for 30 minutes, thereby producing a thermally conductive sheet with a PET film including a thermally conductive sheet having dimensions of 50 mm × 50 mm and a thickness of 200 µm. The PET film was peeled off from the obtained thermally conductive sheet with a PET film, and the thermally conductive sheet was placed between two copper foils, and was heated and pressurized and was cured. After curing, the copper foils were removed by etching, thereby obtaining a cured product of the thermally conductive sheet.

### ·Sheet Production Method B

The above varnish-like thermally conductive resin compositions were applied onto two PET films (dimensions 100 mm × 100 mm) and dried at 80°C for 30 minutes, respectively, thereby producing two thermally conductive sheets with a PET film including a thermally conductive sheet having dimensions of 50 mm × 50 mm and a thickness of 100 µm. The PET films were peeled off from the obtained thermally conductive sheets with a PET film, respectively, and the surface of one thermally conductive sheet in contact with the PET film and the surface of the other thermally conductive sheet opposite to the surface in contact with the PET film were laminated so as to face each other, and the laminate was placed between two copper foils, and was heated and pressurized and was cured. After curing, the copper foils were removed by etching, thereby obtaining a cured product of the thermally conductive sheet having dimensions of 50 mm × 50 mm and a thickness of 200 µm.

### ·Sheet Producing Method C

The above varnish-like thermally conductive resin compositions were applied onto two PET films (dimensions 100 mm × 100 mm) and dried at 80°C for 30 minutes, respectively, thereby producing two thermally conductive sheets with a PET film including a thermally conductive sheet having dimensions of 50 mm × 50 mm and a thickness of 100 µm. The PET films were peeled off from the obtained thermally conductive sheets with a PET film, respectively, and the surface of one thermally conductive sheet in contact with the PET film and the surface of the other thermally conductive sheet in contact with the PET film were laminated so as to face each other, and the laminate was placed between two copper foils, and was heated and pressurized and was cured. After curing, the copper foils were removed by etching, thereby obtaining a cured product of the thermally conductive sheet having dimensions of 50 mm × 50 mm and a thickness of 200 µm.

### <3. Measurement of Physical Properties of Thermally Conductive Sheet>

The amount of warpage of each of the obtained cured thermally conductive sheets was measured. Specifically, as shown in Fig. 1, the thermally conductive sheet obtained by the above-described method was placed such that the central portion of a thermally conductive sheet 10 was in contact with a surface plate 20 and that the end portion of the thermally conductive sheet 10 floated from the surface plate. As shown in Fig. 1, the vertical distance A from the end portion of the thermally conductive sheet 10 to the surface plate was measured and used as the amount of warpage of the thermally conductive sheet. The results are shown in Table 1.

### <4. Performance Evaluation of Thermally Conductive Sheet>

The thermally conductive sheets obtained as described above were evaluated for the following items.

### (Crack Resistance)

For the crack resistance of the thermally conductive sheet, a substrate for a power module was produced using the above-described thermally conductive sheet, and the obtained substrate was placed into an oven at 300°C and allowed to stand for 5 minutes, and then internal cracks were confirmed in a nondestructive manner with a scanning acoustic tomography (SAT). In a case where the presence of cracks was confirmed by the SAT method, the cross-section of the thermally conductive sheet was observed with a scanning electron microscope (SEM). The results are shown in Table 1 according to the following evaluation criteria.

AA: The presence of cracks is not confirmed by the SAT method.

A: The presence of cracks is recognized by the SAT method, but no peeling of 10 µm or more is recognized between the thermally conductive sheet and a support substrate by SEM.

B: Peeling of 10 µm or more is recognized between the thermally conductive sheet and the support substrate by SEM.

### (Heat Resistance After Moisture Absorption Treatment)

The cured thermally conductive sheet having dimensions of 50 mm × 50 mm was allowed to stand under an environment of a temperature of 40°C and a humidity of 90% for 2 days, and then floated in a solder bath at 260°C to 300°C with the copper foil surface facing down, and the presence or absence of appearance abnormality after 30 seconds was examined. The evaluation criteria are as follows. The results are shown in Table 1.

### <Evaluation Criteria>

A: There is no abnormality
B: There is swelling (there is a swelling part as a whole)

### (Thermal Conductive Properties)

The thermally conductive sheet obtained as described above was heat-treated at 180°C and 10 MPa for 40 minutes, thereby obtaining a cured product of the thermally conductive sheet. Next, the thermal conductivity in the thickness direction of the cured product of the thermally conductive sheet was measured by using a laser flash method. Specifically, the thermal conductivity was calculated using the following equation, from the thermal diffusion coefficient (α) measured by the laser flash method (half-time method), the specific heat (Cp) measured by the DSC method, and the density (ρ) measured conforming to JIS-K-6911. The unit of thermal conductivity is W/(m·K). The measurement temperature is 25°C. Thermal conductivity = [W/(m·K)] = α [mm²/s] × Cp [J/kg·K] × ρ[g/cm³]. The results are listed in Table 1 on the basis of the following evaluation criteria.
A: 8W/(m·K) or more
B: Less than 8W/(m·K)

### (Discrimination Properties of Resin-Coated Surface)

The degree of warpage of the obtained cured thermally conductive sheet was visually observed, and whether the resin-coated surface is discriminable was confirmed. The resin-coated surface refers to the surface of the thermally conductive sheet opposite to the surface in contact with the base film. The evaluation criteria are as follows.
A: The resin-coated surface can be visually discriminated.
B: The resin-coated surface cannot be visually discriminated.

**[Table 1]**

| <Composition of thermally conductive composition> | | | Example 1 | Example 2 | Example 3 | Example 4 | Comparative Example 1 | Comparative Example 2 | Comparative Example 3 |
|---|---|---|---|---|---|---|---|---|---|
| Thermosetting resin | Epoxy resin 1 | % by mass | 10.0 | 10.0 | 5.0 | 5.0 | 5.0 | 10.0 | 10.0 |
| | Cyanate resin 1 | | 10.0 | 10.0 | 15.0 | 20.0 | 20.0 | 10.0 | 10.0 |
| Curing agent | Phenol-based curing agent 1 | | 5.2 | 5.2 | 5.0 | - | - | 5.2 | 5.2 |
| Curing catalyst | Curing catalyst 1 | | | - | 0.2 | 0.2 | 0.2 | - | - |
| Inorganic filler | Inorganic filler 1 | | 74.8 | 74.8 | 74.8 | 74.8 | 74.8 | 74.8 | - |
| | Inorganic filler 2 | | - | - | - | - | - | - | 74.8 |
| Total | | | 100.0 | 100.0 | 100.0 | 100.0 | 100.0 | 100.0 | 100.0 |
| <Configuration of thermally conductive sheet> | | | | | | | | | |
| Total thickness | | µm | 200 | 200 | 200 | 200 | 200 | 200 | 200 |
| The number of laminations | | Sheets | 1 | 2 | 2 | 2 | 1 | 2 | 2 |
| Sheet production method | | - | A | B | B | B | A | C | B |
| Amount of warpage (A) | | mm | 1.06 | 0.25 | 1.13 | 1.25 | 1.8 | 0.05 | 0.12 |
| <Performance evaluation of thermally conductive sheet> | | | | | | | | | |
| Crack resistance | | - | AA | AA | A | A | B | AA | A |
| Solder heat resistance after moisture absorption treatment | | - | A | A | A | A | B | A | B |
| Thermal conductive properties | | - | A | A | A | A | A | A | B |
| Discrimination properties of resin-coated surface | | - | A | A | A | A | A | B | B |

The thermally conductive sheets of Examples had a good balance between heat resistance and crack resistance, and the resin-coated surfaces of the sheets were identifiable.

### REFERENCE SIGNS LIST

- 10:: thermally conductive sheet
- 20:: surface plate

This application claims priority on the basis of Japanese Application No. 2020-091379 filed on May 26, 2020.

## Claims

1. A thermally conductive sheet (10) with a metal plate comprising:
a metal plate; and
a thermally conductive sheet (10) laminated over the metal plate and containing a thermosetting resin and boron nitride particles,
wherein the thermosetting resin comprises an epoxy resin and a cyanate resin,
wherein an average particle size of the boron nitride particles is 10 µm or more and 100 µm or less, and
wherein an amount of warpage of the thermally conductive sheet (10) when the metal plate is removed is 0.15 mm or more and 1.30 mm or less, as measured by placing the thermally conductive sheet (10) such that the central portion of the thermally conductive sheet (10) is in contact with a surface plate (20) and the end portion of the thermally conductive sheet (10) is floated from the surface plate (20), measuring a vertical distance A from the end portion of the thermally conductive sheet (10) to the surface plate (20), and using the measured vertical distance A as the amount of warpage of the thermally conductive sheet (10).

2. The thermally conductive sheet (10) with a metal plate according to claim 1, wherein a thickness of the thermally conductive sheet (10) is 100 µm or more and 400 µm or less.

3. A method of producing a thermally conductive sheet (10), comprising:
a step of applying a first thermally conductive resin composition onto a first base film and heating the applied first thermally conductive resin composition to form a first thermally conductive resin layer in a B-stage state, and separating the first thermally conductive resin layer from the first base film to obtain a first thermally conductive resin film;
a step of applying a second thermally conductive resin composition onto a second base film and heating the applied second thermally conductive resin composition to form a second thermally conductive resin layer in a B-stage state, and separating the second thermally conductive resin layer from the second base film to obtain a second thermally conductive resin film;
a step of laminating the second thermally conductive resin film over the first thermally conductive resin film to obtain a laminated film; and
a step of heat-pressing and curing the laminated film to obtain a thermally conductive sheet (10),
wherein the first thermally conductive resin composition and the second thermally conductive resin composition contain a thermosetting resin and boron nitride particles,
wherein the thermosetting resin comprises an epoxy resin and a cyanate resin, and
wherein an average particle size of the boron nitride particles is 10 µm or more and 100 µm or less.

4. The method of producing a thermally conductive sheet (10) according to claim 3,
wherein a thickness of the first thermally conductive resin layer is 50 µm or more and 200 µm or less, and
wherein a thickness of the second thermally conductive resin layer is 50 µm or more and 200 µm or less.

5. The method of producing a thermally conductive sheet (10) according to claim 3 or 4, wherein a thickness of the thermally conductive sheet (10) is 100 µm or more and 400 µm or less.

6. A method of producing a thermally conductive sheet (10), comprising:
a step of applying a thermally conductive resin composition onto a base film and heating the applied thermally conductive resin composition to form a thermally conductive resin layer in a B-stage state, and separating the thermally conductive resin layer from the base film to obtain a thermally conductive resin film; and
a step of heat-pressing and curing the thermally conductive resin film to obtain a thermally conductive sheet (10),
wherein the thermally conductive resin composition contains a thermosetting resin composition and boron nitride particles,
wherein the thermosetting resin comprises an epoxy resin and a cyanate resin, and
wherein an average particle size of the boron nitride particles is 10 µm or more and 100 µm or less.

7. The method of producing a thermally conductive sheet (10) according to claim 6, wherein a thickness of the thermally conductive resin layer is 100 µm or more and 400 µm or less.

## Patentansprüche

1. Wärmeleitende Folie (10) mit einer Metallplatte, umfassend:
eine Metallplatte; und
eine wärmeleitende Folie (10), die über die Metallplatte laminiert ist und ein wärmehärtbares Harz und Bornitridteilchen enthält,
wobei das wärmehärtbare Harz ein Epoxidharz und ein Cyanatharz umfasst,
wobei eine durchschnittliche Teilchengröße der Bornitridteilchen 10 µm oder mehr und 100 µm oder weniger beträgt, und
wobei das Ausmaß des Verzugs der wärmeleitenden Folie (10), wenn die Metallplatte entfernt wird, 0,15 mm oder mehr und 1,30 mm oder weniger beträgt, gemessen durch Anordnen der wärmeleitenden Folie (10) auf eine Weise, dass der mittlere Abschnitt der wärmeleitenden Folie (10) in Kontakt mit einer Oberflächenplatte (20) ist und der Endabschnitt der wärmeleitenden Folie (10) von der Oberflächenplatte (20) abhebt, Messen eines vertikalen Abstands A von dem Endabschnitt der wärmeleitenden Folie (10) zu der Oberflächenplatte (20) und Verwenden des gemessenen vertikalen Abstands A als den Betrag des Ausmaßes des Verzugs der wärmeleitenden Folie (10).

2. Wärmeleitende Folie (10) mit einer Metallplatte nach Anspruch 1, wobei eine Dicke der wärmeleitenden Folie (10) 100 µm oder mehr und 400 µm oder weniger beträgt.

3. Verfahren zur Herstellung einer wärmeleitenden Folie (10), umfassend:
einen Schritt des Auftragens einer ersten wärmeleitenden Harzzusammensetzung auf eine erste Basisfolie und des Erwärmens der aufgetragenen ersten wärmeleitenden Harzzusammensetzung, um eine erste wärmeleitende Harzschicht in einem B-Zustand zu bilden, und des Trennens der ersten wärmeleitenden Harzschicht von der ersten Basisfolie, um eine erste wärmeleitende Harzfolie zu erhalten;
einen Schritt des Auftragens einer zweiten wärmeleitenden Harzzusammensetzung auf eine zweite Basisfolie und des Erwärmens der aufgetragenen zweiten wärmeleitenden Harzzusammensetzung, um eine zweite wärmeleitende Harzschicht in einem B-Zustand zu bilden, und des Trennens der zweiten wärmeleitenden Harzschicht von der zweiten Basisfolie, um eine zweite wärmeleitende Harzfolie zu erhalten;
einen Schritt des Laminierens der zweiten wärmeleitenden Harzfolie über die erste wärmeleitende Harzfolie, um eine laminierte Folie zu erhalten; und
einen Schritt des Heißpressens und Aushärtens der laminierten Folie, um eine wärmeleitende Folie (10) zu erhalten,
wobei die erste wärmeleitende Harzzusammensetzung und die zweite wärmeleitende Harzzusammensetzung ein wärmehärtbares Harz und Bornitridteilchen enthalten,
wobei das wärmehärtbare Harz ein Epoxidharz und ein Cyanatharz umfasst, und
wobei eine durchschnittliche Teilchengröße der Bornitridteilchen 10 µm oder mehr und 100 µm oder weniger beträgt.

4. Verfahren zur Herstellung einer wärmeleitenden Folie (10) nach Anspruch 3,
wobei die Dicke der ersten wärmeleitenden Harzschicht 50 µm oder mehr und 200 µm oder weniger beträgt, und
wobei die Dicke der zweiten wärmeleitenden Harzschicht 50 µm oder mehr und 200 µm oder weniger beträgt.

5. Verfahren zur Herstellung einer wärmeleitenden Folie (10) nach Anspruch 3 oder 4, wobei die Dicke der wärmeleitenden Folie (10) 100 µm oder mehr und 400 µm oder weniger beträgt.

6. Verfahren zur Herstellung einer wärmeleitenden Folie (10), umfassend:
einen Schritt des Auftragens einer wärmeleitenden Harzzusammensetzung auf eine Basisfolie und des Erhitzens der aufgetragenen wärmeleitenden Harzzusammensetzung, um eine wärmeleitende Harzschicht in einem B-Zustand zu bilden, und des Trennens der wärmeleitenden Harzschicht von der Basisfolie, um eine wärmeleitende Harzfolie zu erhalten; und
einen Schritt des Heißpressens und Aushärtens der wärmeleitenden Harzfolie, um eine wärmeleitende Folie (10) zu erhalten,
wobei die wärmeleitende Harzzusammensetzung eine wärmehärtbare Harzzusammensetzung und Bornitridteilchen enthält,
wobei das wärmehärtbare Harz ein Epoxidharz und ein Cyanatharz umfasst, und
wobei eine durchschnittliche Teilchengröße der Bornitridteilchen 10 µm oder mehr und 100 µm oder weniger beträgt.

7. Verfahren zur Herstellung einer wärmeleitenden Folie (10) nach Anspruch 6, wobei die Dicke der wärmeleitenden Harzschicht 100 µm oder mehr und 400 µm oder weniger beträgt.

## Revendications

1. Feuille thermiquement conductrice (10) avec une plaque métallique comportant :
une plaque métallique ; et
une feuille thermiquement conductrice (10) stratifiée sur la plaque métallique et contenant une résine thermodurcissable et des particules de nitrure de bore,
dans laquelle la résine thermodurcissable comporte une résine époxyde et une résine de cyanate,
dans laquelle une taille de particule moyenne des particules de nitrure de bore est de 10 µm ou plus et de 100 µm ou moins, et
dans laquelle une quantité de gauchissement de la feuille thermiquement conductrice (10) lorsque la plaque métallique est retirée est de 0,15 mm ou plus et de 1,30 mm ou moins, lorsque mesurée en plaçant la feuille thermiquement conductrice (10) de telle sorte que la partie centrale de la feuille thermiquement conductrice (10) est en contact avec une plaque de surface (20) et la partie d'extrémité de la feuille thermiquement conductrice (10) est flottante par rapport à la plaque de surface (20), en mesurant une distance verticale A de la partie d'extrémité de la feuille thermiquement conductrice (10) à la plaque de surface (20), et en utilisant la distance verticale A mesurée comme la quantité de gauchissement de la feuille thermiquement conductrice (10).

2. Feuille thermiquement conductrice (10) avec une plaque métallique selon la revendication 1, dans laquelle une épaisseur de la feuille thermiquement conductrice (10) est de 100 µm ou plus et de 400 µm ou moins.

3. Procédé de production d'une feuille thermiquement conductrice (10), comportant :
une étape consistant à appliquer une première composition de résine thermiquement conductrice sur un premier film de base et chauffer la première composition de résine thermiquement conductrice appliquée pour former une première couche de résine thermiquement conductrice dans un état de stade B, et séparer la première couche de résine thermiquement conductrice du premier film de base afin d'obtenir un premier film de résine thermiquement conductrice ;
une étape consistant à appliquer une seconde composition de résine thermiquement conductrice sur un second film de base et chauffer la seconde composition de résine thermiquement conductrice appliquée pour former une seconde couche de résine thermiquement conductrice dans un état de stade B, et séparer la seconde couche de résine thermiquement conductrice du second film de base afin d'obtenir un second film de résine thermiquement conductrice ;
une étape consistant à stratifier le second film de résine thermiquement conductrice sur le premier film de résine thermiquement conductrice pour obtenir un film stratifié ; et
une étape consistant à presser à chaud et durcir le film stratifié pour obtenir une feuille thermiquement conductrice (10),
dans lequel la première composition de résine thermiquement conductrice et la seconde composition de résine thermiquement conductrice contiennent une résine thermodurcissable et des particules de nitrure de bore,
dans lequel la résine thermodurcissable comporte une résine époxyde et une résine de cyanate, et
dans lequel la taille de particule moyenne des particules de nitrure de bore est de 10 µm ou plus et de 100 µm ou moins.

4. Procédé de production d'une feuille thermiquement conductrice (10) selon la revendication 3,
dans lequel une épaisseur de la première couche de résine thermiquement conductrice est de 50 µm ou plus et de 200 µm ou moins, et
dans lequel une épaisseur de la seconde couche de résine thermiquement conductrice est de 50 µm ou plus et de 200 µm ou moins.

5. Procédé de production d'une feuille thermiquement conductrice (10) selon la revendication 3 ou 4, dans lequel une épaisseur de la feuille thermiquement conductrice (10) est de 100 µm ou plus et de 400 µm ou moins.

6. Procédé de production d'une feuille thermiquement conductrice (10), comportant :
une étape consistant à appliquer une composition de résine thermiquement conductrice sur un film de base et chauffer la composition de résine thermiquement conductrice appliquée pour former une couche de résine thermiquement conductrice dans un état de stade B, et séparer la couche de résine thermiquement conductrice du film de base afin d'obtenir un film de résine thermiquement conductrice ; et
une étape consistant à presser à chaud et durcir le film de résine thermiquement conductrice pour obtenir une feuille thermiquement conductrice (10),
dans lequel la composition de résine thermiquement conductrice contient une composition de résine thermodurcissable et des particules de nitrure de bore,
dans lequel la résine thermodurcissable comporte une résine époxyde et une résine de cyanate, et
dans lequel une taille de particule moyenne des particules de nitrure de bore est de 10 µm ou plus et de 100 µm ou moins.

7. Procédé de production d'une feuille thermiquement conductrice (10) selon la revendication 6, dans lequel une épaisseur de la couche de résine thermiquement conductrice est de 100 µm ou plus et de 400 µm ou moins.
